(19) **Europäisches Patentamt / European Patent Office / Office européen des brevets**

(11) **EP 4 752 580 A1**

(12) # EUROPEAN PATENT APPLICATION
published in accordance with Art. 153(4) EPC

(43) Date of publication:
03.06.2026 Bulletin 2026/23

(21) Application number: 24863084.0

(22) Date of filing: 22.08.2024

(51) International Patent Classification (IPC):
*G01R 31/396* $^{(2019.01)}$    *G01R 31/367* $^{(2019.01)}$
*G01R 31/385* $^{(2019.01)}$    *G01R 19/165* $^{(2006.01)}$

(52) Cooperative Patent Classification (CPC):
G01R 19/165; G01R 31/367; G01R 31/385;
G01R 31/396

(86) International application number:
PCT/KR2024/012516

(87) International publication number:
WO 2025/053503 (13.03.2025 Gazette 2025/11)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 05.09.2023 KR 20230117958

(71) Applicant: **LG Energy Solution, Ltd.**
**Seoul 07335 (KR)**

(72) Inventors:
• **PARK, Hyeon Uk**
**Daejeon 34122 (KR)**
• **AN, Mi Ae**
**Daejeon 34122 (KR)**

(74) Representative: **BCKIP Part mbB**
**Landsberger Straße 98**
**80339 München (DE)**

(54) **DATA PROCESSING DEVICE AND OPERATING METHOD THEREOF**

(57) A battery analysis apparatus according to an embodiment disclosed in this document may include an acquisition unit configured to acquire time-series voltage data of a plurality of battery cells, a calculation unit configured to calculate the average voltage of the plurality of battery cells and the voltage deviations between each of the plurality of battery cells based on the time-series voltage data, a generation unit configure to generate entropy-voltage data representing the voltage deviations as entropy values based on the voltage deviations of the plurality of battery cells, and a diagnostic unit configured to diagnose abnormalities in the plurality of battery cells based on the entropy-voltage data.

FIG.1

Description

## TECHNICAL FIELD

### CROSS REFERENCE TO RELATED APPLICATION

This application claims priority to Korean Patent Application No. 10-2023-0117958, filed September 5, 2023, the entire contents of which is incorporated herein for all purposes by this reference.

### TECHNICAL FIELD

The embodiments disclosed in this document relate to a data processing apparatus and method.

## BACKGROUND ART

Recently, research and development on secondary batteries have been actively conducted. Here, the secondary battery is a rechargeable battery and includes all of the conventional Ni/Cd batteries, Ni/MH batteries, and recent lithium ion batteries. Among the secondary batteries, Lithium ion batteries have an advantage of much higher energy density than the conventional Ni/Cd batteries and Ni/MH batteries. In addition, Lithium-ion batteries can be manufactured small and lightweight enough to be used as power sources for mobile devices and recently expand their usage range to power sources for electric vehicles, drawing attention as a next-generation energy storage medium.

In the process of handling data for these secondary batteries, an outlier filtering technique that utilizes the characteristics of the median has been employed to remove outliers. For example, a technique was used to arrange process data in order of size and remove outliers by considering any data that falls outside the range between the lower inner fence and the upper inner fence, determined using quartiles in a box plot, as an outlier.

## DISCLOSURE

## TECHNICAL PROBLEM

However, the existing outlier filtering technique has the problem that the lower and upper inner fences of the box plot are fixed, which fails to reflect the process capability of battery manufacturing equipment, risking the removal of normal data.

The embodiments disclosed in this document aim to provide a data processing apparatus and method capable of determining the range for outlier removal by considering the process capability of battery manufacturing equipment.

The technical objects of the embodiments disclosed in this document are not limited to the aforesaid, and other objects not described herein will be clearly understood by those skilled in the art from the description below.

## TECHNICAL SOLUTION

A data processing apparatus according to an embodiment disclosed in this document may include a communication circuit configured to acquire process data related to a battery manufacturing process, and a processor configured to filter the process data, wherein the processor may generate a reference distribution profile following a standard normal distribution based on the process data, calculate a process capability parameter related to the process capability of a process equipment involved in the battery manufacturing process based on the process data, generate a box plot for the battery manufacturing process based on the reference distribution profile and the process capability parameter, and remove data falling outside a critical range corresponding to the box plot from the process data.

In the data processing apparatus disclosed in this document, the box plot may include quartiles, an interquartile range, a minimum limit, and a maximum limit, and the processor may set the quartiles and the interquartile range based on the reference distribution profile, and set the minimum limit and the maximum limit based on at least some of the quartiles, the interquartile range, and the process capability parameter.

In the data processing apparatus disclosed in this document, the critical range may be the interval between the minimum limit and the maximum limit.

In the data processing apparatus disclosed in this document, the processor may calculate a scale value based on the process capability parameter, and sets the minimum limit and the maximum limit based on Equations 1 and 2:

$$[\text{Equation 1}]$$

$$\text{Minimum limit} = Q1 - k \cdot IQR$$

$$[\text{Equation 2}]$$

$$\text{Minimum limit} = Q3 + k \cdot IQR$$

(In Equations 1 and 2, Q1 denotes the first quartile, Q3 denotes the third quartile, k denotes the scale value, and IQR denotes the interquartile range.)

In the data processing apparatus disclosed in this document, the processor may calculate the scale value based on Equation 3:

$$[\text{Equation 3}]$$

$$k = -0.5 + (n/1.35)$$

(In Equation 3, k denotes the scale value, and n denotes the process capability parameter.)

In the data processing apparatus disclosed in this document, the processor may calculate a difference value between a maximum value and a minimum value among numerical values of a predetermined process parameter based on the process data, calculate a standard deviation value of the numerical values of the process parameter based on the process data, and calculate the process capability parameter based on the difference value and the standard deviation value.

In the data processing apparatus disclosed in this document, the processor may calculate the process capability parameter based on Equation 4:

$$[\text{Equation 4}]$$

$$n=T/(2\cdot s)$$

(In Equation 4, n denotes the process capability parameter, T denotes the difference value, and s denotes the standard deviation value.)

A data processing method according to an embodiment disclosed in this document may include acquiring process data related to a battery manufacturing process, generating a reference distribution profile following a standard normal distribution based on the process data, calculating a process capability parameter related to the process capability of a process equipment involved in the battery manufacturing process based on the process data, generating a box plot for the battery manufacturing process based on the reference distribution profile and the process capability parameter, and removing data falling outside a critical range corresponding to the box plot from the process data.

In the data processing method disclosed in this document, the box plot may include quartiles, an interquartile range, a minimum limit, and a maximum limit, and the generating of the box plot may include setting the quartiles and the interquartile range based on the reference distribution profile, and setting the minimum limit and the maximum limit based on at least some of the quartiles, the interquartile range, and the process capability parameter.

In the data processing method disclosed in this document, the critical range may be the interval between the minimum limit and the maximum limit.

The data processing method disclosed in this document may further include calculating a scale value based on the process capability parameter, and the minimum limit and the maximum limit may be set based on Equations 1 and 2.

In the data processing method disclosed in this document, the scale value may be calculated based on Equation 3.

In the data processing method disclosed in this document, the calculating of the process capability parameter may include calculating a difference value between a maximum value and a minimum value among numerical values of a predetermined process parameter based on the process data, calculating a standard deviation value of the numerical values of the process parameter based on the process data, and calculating the process capability parameter based on the difference value and the standard deviation value.

In the data processing method disclosed in this document, the process capability parameter may be calculated based on Equation 4.

**ADVANTAGEOUS EFFECTS**

According to the embodiments disclosed in this document, it is possible to improve existing conservative outlier filtering techniques by determining the range for outlier removal based on the process capability of battery manufacturing equipment.

In addition, various effects identified directly or indirectly through this document can be provided.

**DESCRIPTION OF DRAWINGS**

FIG. 1 is a diagram schematically illustrating a reference distribution profile and a typical box plot based on process data;
FIG. 2 is a block diagram illustrating a data processing apparatus according to an embodiment;
FIG. 3 is a diagram illustrating an exemplary box plot generated by a data processing apparatus according to an embodiment; and
FIG. 4 is a flowchart illustrating the operation of a data processing apparatus according to an embodiment.

**MODE FOR INVENTION**

Hereinafter, various embodiments of the present invention will be described with reference to the accompanying drawings. However, the description is not intended to limit the present invention to particular embodiments, and it should be construed as including various modifications, equivalents, and/or alternatives of the embodiments described herein.

Various embodiments disclosed in this document and terms used therein are not intended to limit the technical features described in this document to specific embodiments, and the disclosure should be construed as including various modifications, equivalents, and/or alternatives of the corresponding embodiments. In connection with the description of the drawings, like reference numbers may be used for like or related elements. The singular form of a noun corresponding to an item may include one item or a plurality of items unless the relevant context clearly dictates otherwise.

In this document, each of the phrases such as "A or B", "at least one of A and B", "at least one of A or B", "A, B or C", "at least one of A, B and C", and "at least one of A, B, or C" may include any of the items listed together in the corresponding phrase or any possible combination thereof. Terms such as "the first", "the second", "first", "second", "A", "B", "(a)", or "(b)" may be used simply to distinguish such components from other components and do not limit the corresponding components in other aspects (e.g., importance or order) unless otherwise stated specifically.

In this document, when it is mentioned that a (e.g., first) component is "connected", "coupled", "accessed", with or without the terms "functionally" or "communicatively", to another (e.g., second) component, it means that the component can be connected to the other component directly (e.g., wired), wirelessly, or via a third component.

According to various embodiments, each component (e.g., module or program) of the components described above may include a single object or a plurality of objects, and some of the multiple objects may be separately disposed in other components. According to various embodiments, one or more components or operations among the aforementioned components may be omitted, or one or more other components or operations may be added. Alternatively or additionally, a plurality of components (e.g., modules or programs) may be integrated into a single component. In this case, the integrated component may perform one or more functions of each of the plurality of components identically or similarly to those performed by the corresponding component of the plurality of components prior to the integration. According to various embodiments, operations performed by modules, programs, or other components are executed sequentially, in parallel, iteratively, or heuristically, or one or more of the operations are executed in a different order, omitted, or one or more other operations may be added.

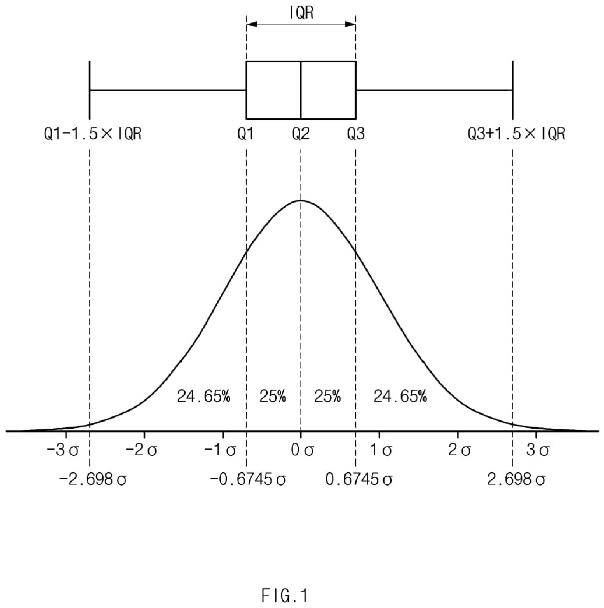

FIG. 1 is a diagram schematically illustrating a reference distribution profile and a typical box plot based on process data.

With reference to FIG. 1, a reference distribution profile generated based on process data related to the battery process and a typical box plot generated based on the reference distribution profile are shown.

Here, process data may refer to data related to process parameters (e.g., temperature, output, etc.) obtained from the battery manufacturing equipment and/or inspection data (e.g., dimensional data, thickness data, etc.) acquired from an automated inspection device installed in the battery manufacturing equipment. The reference distribution profile may represent a continuous probability distribution of process data for a predetermined process parameter. Additionally, the reference distribution profile may follow a standard normal distribution.

The box plot may include quartiles (Q1, Q2, and Q3), interquartile range (IQR), the lower inner fence (Q1 - 1.5 * IQR), and the upper inner fence (Q3 + 1.5 * IQR).

The box plot can be generated based on the median of the process data. That is, the second quartile (Q2) can be set as the median of the process data.

The quartiles (Q1, Q2, and Q3) divide the reference distribution profile into four equal parts, representing the values at the 25th, 50th, and 75th percentiles, respectively. Specifically, within the reference distribution profile, the range below the first quartile (Q1), the range from Q1 to the second quartile (Q2), the range from Q2 to the third quartile (Q3), and the range above Q3 each contain one-fourth of the total process data.

For example, when the quartiles are represented using a probability distribution function $F(x)$, $F(Q1)=0.25$, $F(Q2)=0.5$, and $F(Q3)=0.75$. Consequently, in a standard normal distribution, the first quartile (Q1) may be $-0.6745\sigma$, the second quartile (Q2) may be 0, and the third quartile (Q3) may be $0.6745\sigma$, where $\sigma$ is the standard deviation of the process data.

The interquartile range (IQR) may be defined as the range between the first quartile (Q1) and the third quartile (Q3). Consequently, the IQR may be $1.349\sigma$.

According to the general definition of a box plot, the lower inner fence is defined as "Q1 - (1.5 * IQR)". Consequently, the lower inner fence may be $-2.698\sigma$. Similarly, the upper inner fence is defined as "Q3 + (1.5 * IQR)". Thus, the upper inner fence may be $2.698\sigma$.

According to the existing outlier removal methods, any data that falls outside the range between the lower inner fence and the upper inner fence of a typical box plot, based on the reference distribution profile of the process data, is considered an outlier and removed. However, this approach does not reflect the process capability of the battery manufacturing equipment, which may lead to the removal of normal data as well.

Therefore, when removing outliers from process data, there is a need for a technique that allows for flexible setting of the outlier removal range, taking into account the process capability of the manufacturing equipment.

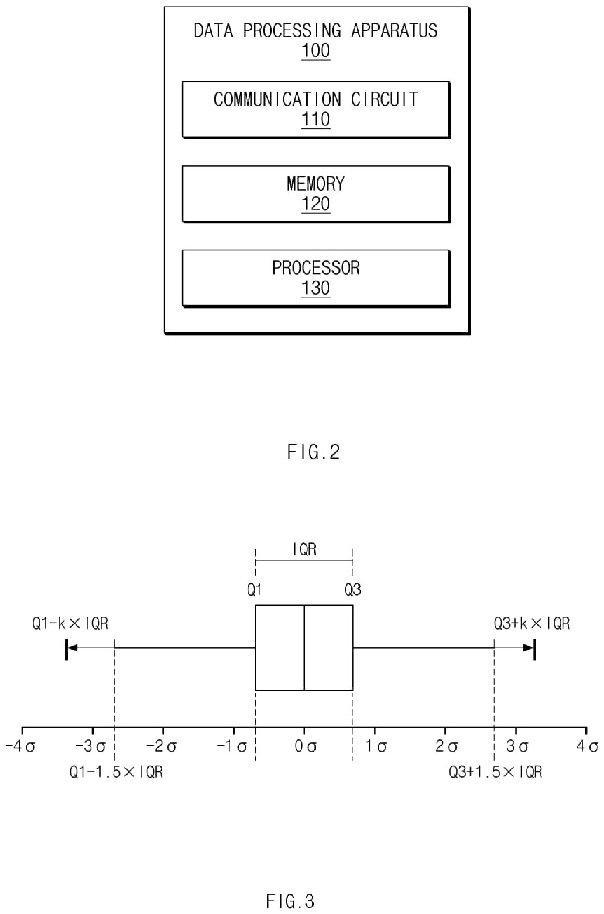

Hereinafter, the data processing apparatus according to an embodiment of the present disclosure will be described with reference to FIGS. 2 and 3.

FIG. 2 is a block diagram illustrating a data processing apparatus according to an embodiment. FIG. 3 is a diagram illustrating an exemplary box plot generated by a data processing apparatus according to an embodiment.

With reference to FIG. 2, the data processing apparatus 100 may include a communication circuit 110, a memory 120, and a processor 130. According to an embodiment, the data processing apparatus 100 shown in FIG. 2 may further include at least one additional component (e.g., a display, input device, or output device) other than the components illustrated in FIG. 2.

According to an embodiment, the communication circuit 110 may establish a communication channel between the data processing apparatus 100 and an external electronic device (e.g., battery manufacturing equipment) and may transmit and receive data to and from the external electronic device through the established communication channel. According to an embodiment, the communication channel may be established based on a wired network and/or a wireless network. In an embodiment, the wired network may be based on local area network (LAN) or power line communication. In an embodiment, the wireless network may be based on a short range communication network (e.g., Bluetooth, wireless fidelity (Wi-Fi), infrared data association (IrDA)) or a long-range communication network (e.g., cellular network, 4G networks and 5G networks).

According to an embodiment, the communication circuit 110 may acquire process data related to the battery manufacturing process. Here, process data may refer to data related to process parameters (e.g., temperature, output, etc.) obtained from the battery manufacturing equipment and/or inspection data (e.g., dimensional data, thickness data, etc.) acquired from an automated inspection device installed in the battery manufacturing equipment.

According to an embodiment, the memory 120 may include volatile memory and/or non-volatile memory.

According to an embodiment, the memory 120 may store data used by at least one component of the data processing apparatus 100 (e.g., processor 130). For example, the data may include software (or related instructions), input data, or output data. In an embodiment, the instructions may be executed by the processor 130 for the data processing apparatus 100 to perform operations defined by the instructions.

According to an embodiment, the processor 130 may include a central processing unit, an application processor, a graphic processing unit, a neural processing unit (NPU), an image signal processor, a sensor hub processor, or a communication processor.

According to an embodiment, the processor 130 may execute software stored in the memory 120 to control at least one other component (e.g., hardware or software component) connected to the processor 130 in the data processing apparatus 100 and perform various data processing or computations.

According to an embodiment, the processor 130 may filter the process data acquired by the communication circuit 110.

According to an embodiment, the processor 130 may generate a reference distribution profile that follows a standard normal distribution based on the process data. Here, the reference distribution profile may represent a continuous probability distribution of process data for a predetermined process parameter.

According to an embodiment, the processor 130 may calculate process capability parameter related to the process capability of the process equipment involved in the battery manufacturing process based on the process data.

According to an embodiment, the processor 130 may calculate the difference value between the maximum value and the minimum value among the numerical values of a predetermined process parameter based on the process data. For example, when the process data represents temperatures detected by the battery manufacturing equipment, the processor 130 may calculate the difference value between the maximum and minimum temperature values.

According to an embodiment, the processor 130 may calculate the standard deviation value of the numerical values of a predetermined process parameter based on the process data. For example, when the process data represents temperatures detected by the battery manufacturing equipment, the processor 130 may calculate the standard deviation value of the detected temperature values.

According to an embodiment, the processor 130 may calculate the process capability parameter based on Equation 1.

[Equation 1]

$$n = T/(2 \cdot s)$$

In Equation 1, n denotes the process capability parameter, T denotes the difference value between the maximum value and the minimum value among the numerical values of the predetermined process parameter, and s denotes the standard deviation value of the numerical values of the predetermined process parameter.

According to an embodiment, the processor 130 may generate a box plot for the battery process based on the reference distribution profile and the process capability parameter. The box plot may include quartiles, the interquartile range, the minimum limit, and the maximum limit.

According to an embodiment, the processor 130 may set the quartiles and the interquartile range based on the reference distribution profile. The processor 130 may set the values of the variables that divide the data of the reference distribution profile into four equal parts as quartiles. For example, the processor 130 may set the median of the reference distribution profile as the second quartile Q2, the value at which the probability distribution function F(x) equals 0.25 as the first quartile Q1, and the value at which F(x) equals 0.75 as the third quartile Q3. The processor 130 may set the range between the first quartile and the third quartile as the interquartile range.

According to an embodiment, the processor 130 may set the minimum limit and the maximum limit based on at least some of the quartiles, the interquartile range, and the process capability parameter.

According to an embodiment, the processor 130 may set the minimum limit and the maximum limit based on Equations 2 and 3.

[Equation 2]

$$\text{Minimum limit} = Q1 - k \cdot IQR$$

[Equation 3]

$$\text{Minimum limit} = Q3 + k \cdot IQR$$

In Equations 2 and 3, Q1 denotes the first quartile, Q3 denotes the third quartile, k denotes the scale value, and IQR denotes the interquartile range. Here, the scale value is related to the process capability parameter, and the method for calculating the scale value will be described below.

According to an embodiment, the processor 130 may calculate the scale value based on the process capability parameter. For example, the processor 130 may calculate the scale value based on Equation 4.

[Equation 4]

$$k = -0.5 + (n/1.35)$$

In Equation 4, k denotes the scale value, and n denotes the process capability parameter.

According to an embodiment, the processor 130 may remove data that falls outside the critical range corresponding to the box plot from the process data. The critical range may, for example, refer to the interval between the minimum limit and the maximum limit.

In this way, the data processing apparatus 100 is capable of flexibly setting the range for outlier removal by newly establishing the minimum limit and maximum limit based on the process capability parameter of the battery manufacturing equipment, thereby reflecting the process capability of the process equipment.

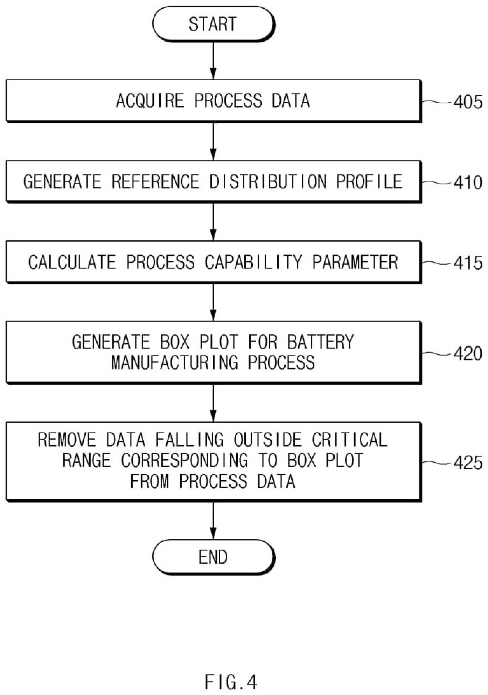

FIG. 4 is a flowchart illustrating the operation of a data processing apparatus according to an embodiment. FIG. 4 may illustrate the operation of the data processing apparatus 100 in FIG. 1, and the description may be made on the basis of the configuration shown in FIG. 1.

The embodiment shown in FIG. 4 is merely one embodiment, and the order of operations according to various embodiments of the present invention may be different from that shown in FIG. 4, and some operations shown in FIG. 4 may be omitted, changed in order, or merged.

With reference to FIG. 4, in operation 405, the data processing apparatus 100 may acquire process data related to the battery manufacturing process. Here, process data may refer to data related to process parameters (e.g., temperature, output, etc.) obtained from the battery manufacturing equipment and/or inspection data (e.g., dimensional data, thickness data, etc.) acquired from an automated inspection device installed in the battery manufacturing equipment.

In operation 410, the data processing apparatus 100 may generate a reference distribution profile that follows a standard normal distribution based on the process data acquired in operation 405. Here, the reference distribution profile may represent a continuous probability distribution of process data for a predetermined process parameter.

In operation 415, the data processing apparatus 100 may calculate process capability parameter related to the process capability of the process equipment involved in the battery manufacturing process based on the process data acquired in operation 405.

According to an embodiment, the data processing apparatus 100 may calculate the difference value between the maximum value and the minimum value among the numerical values of a predetermined process parameter based on the process data. For example, when the process data represents temperatures detected by the battery manufacturing equipment, the data processing apparatus 100 may calculate the difference value between the maximum and minimum temperature values among the detected temperature values.

According to an embodiment, the data processing apparatus 100 may calculate the standard deviation value of the numerical values of a predetermined process parameter based on the process data. For example, when the process data represents temperatures detected by the battery manufacturing equipment, the data processing apparatus 100 may calculate the standard deviation value of the detected temperature values.

According to an embodiment, the data processing apparatus 100 may calculate the process capability parameter based on Equation 1.

In operation 420, the data processing apparatus 100 may generate a box plot for the battery manufacturing process based on the reference distribution profile created in operation 410 and the process capability parameter calculated in operation 415. The box plot may include quartiles, the interquartile range, the minimum limit, and the maximum limit.

According to an embodiment, the data processing apparatus 100 may set the quartiles and the interquartile range based on the reference distribution profile. The data processing apparatus 100 may set the values of the variables that divide the data of the reference distribution profile into four equal parts as quartiles. For example, the data processing apparatus 100 may set the median of the reference distribution profile as the second quartile Q2, the value at which the probability distribution function F(x) equals 0.25 as the first quartile Q1, and the value at which F(x) equals 0.75 as the third quartile Q3. The data processing apparatus 100 may set the range between the first quartile and the third quartile as the interquartile range.

According to an embodiment, the data processing apparatus 100 may set the minimum limit and the maximum limit based on at least some of the quartiles, the interquartile range, and the process capability parameter.

According to an embodiment, the data processing apparatus 100 may set the minimum limit and the maximum limit based on Equations 2 and 3.

According to an embodiment, the data processing apparatus 100 may calculate the scale value based on the process capability parameter. For example, the data processing apparatus 100 may calculate the scale value based on Equation 4.

In operation 425, the data processing apparatus 100 may remove data that falls outside the critical range corresponding to the box plot from the process data. The critical range may, for example, refer to the interval between the minimum limit and the maximum limit.

Also, the terms such as "comprise", "include", or "have" used above implies that the corresponding component may be present unless otherwise stated specifically, and thus it should be construed as being able to further include other components rather than exclude other components. Unless otherwise defined herein, all terms including technical or scientific terms used herein have the same meanings as commonly understood by those skilled in the art to which the present invention belongs. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

**Claims**

1. A data processing apparatus comprising:

   a communication circuit configured to acquire process data related to a battery manufacturing process; and
   a processor configured to filter the process data, wherein the processor generates a reference distribution profile following a standard normal distribution based on the process data, calculates a process capability parameter related to the process capability of a process equipment involved in the battery manufacturing process based on the process data, generates a box plot for the battery manufacturing process based on the reference distribution profile and the process capability parameter, and removes data falling outside a critical range corresponding to the box plot from the process data.

2. The data processing apparatus of claim 1, wherein the box plot comprises quartiles, an interquartile range, a minimum limit, and a maximum limit, and the processor sets the quartiles and the interquartile range based on the reference distribution profile, and sets the minimum limit and the maximum limit based on at least some of the quartiles, the interquartile range, and the process capability parameter.

3. The data processing apparatus of claim 2, wherein the critical range is the interval between the minimum limit and the maximum limit.

4. The data processing apparatus of claim 2, wherein the processor calculates a scale value based on the process capability parameter, and sets the minimum limit and the maximum limit based on Equations 1 and 2:

$$[\text{Equation } 1]$$

$$\text{Minimum limit} = Q1 - k \cdot IQR$$

$$[\text{Equation } 2]$$

$$\text{Minimum limit} = Q3 + k \cdot IQR$$

(In Equations 1 and 2, Q1 denotes the first quartile, Q3 denotes the third quartile, k denotes the scale value, and IQR denotes the interquartile range.)

5. The data processing apparatus of claim 4, wherein the processor calculates the scale value based on Equation 3:

$$[\text{Equation } 3]$$

$$k = -0.5 + (n/1.35)$$

(In Equation 3, k denotes the scale value, and n denotes the process capability parameter.)

6. The data processing apparatus of claim 1, wherein the processor calculates a difference value between a maximum value and a minimum value among numerical values of a predetermined process parameter based on the process data, calculates a standard deviation value of the numerical values of the process parameter based on the process data, and calculates the process capability parameter based on the difference value and the standard deviation value.

7. The data processing apparatus of claim 6, wherein the processor calculates the process capability parameter based on Equation 4:

[Equation 4]

$$n=T/(2 \cdot s)$$

(In Equation 4, n denotes the process capability parameter, T denotes the difference value, and s denotes the standard deviation value.)

8. A data processing method comprising:

acquiring process data related to a battery manufacturing process;
generating a reference distribution profile following a standard normal distribution based on the process data;
calculating a process capability parameter related to the process capability of a process equipment involved in the battery manufacturing process based on the process data;
generating a box plot for the battery manufacturing process based on the reference distribution profile and the process capability parameter; and
removing data falling outside a critical range corresponding to the box plot from the process data.

9. The data processing method of claim 8, wherein the box plot comprises quartiles, an interquartile range, a minimum limit, and a maximum limit, and the generating of the box plot comprises setting the quartiles and the interquartile range based on the reference distribution profile, and setting the minimum limit and the maximum limit based on at least some of the quartiles, the interquartile range, and the process capability parameter.

10. The data processing method of claim 9, wherein the critical range is the interval between the minimum limit and the maximum limit.

11. The data processing method of claim 9, further comprising calculating a scale value based on the process capability parameter, and the minimum limit and the maximum limit are set based on Equations 1 and 2:

[Equation 1]

$$\text{Minimum limit} = Q1 - k \cdot IQR$$

[Equation 2]

$$\text{Minimum limit} = Q3 + k \cdot IQR$$

(In Equations 1 and 2, Q1 denotes the first quartile, Q3 denotes the third quartile, k denotes the scale value, and IQR denotes the interquartile range.)

12. The data processing method of claim 11, wherein the scale value is calculated based on Equation 3:

[Equation 3]

$$k = -0.5 + (n/1.35)$$

(In Equation 3, k denotes the scale value, and n denotes the process capability parameter.)

13. The data processing method of claim 8, wherein the calculating of the process capability parameter comprises:

calculating a difference value between a maximum value and a minimum value among numerical values of a predetermined process parameter based on the process data;
calculating a standard deviation value of the numerical values of the process parameter based on the process data; and
calculating the process capability parameter based on the difference value and the standard deviation value.

14. The data processing method of claim 13, wherein the process capability parameter is calculated based on Equation 4:

[Equation 4]

$$n = T/(2 \cdot s)$$

(In Equation 4, n denotes the process capability parameter, T denotes the difference value, and s denotes the standard deviation value.)

FIG.1

DATA PROCESSING APPARATUS
100

COMMUNICATION CIRCUIT
110

MEMORY
120

PROCESSOR
130

FIG.2

IQR

Q1     Q3

Q1−k×IQR                              Q3+k×IQR

Q1−1.5×IQR                            Q3+1.5×IQR

−4σ    −3σ    −2σ    −1σ    0σ    1σ    2σ    3σ    4σ

FIG.3

START

ACQUIRE PROCESS DATA — 405

GENERATE REFERENCE DISTRIBUTION PROFILE — 410

CALCULATE PROCESS CAPABILITY PARAMETER — 415

GENERATE BOX PLOT FOR BATTERY MANUFACTURING PROCESS — 420

REMOVE DATA FALLING OUTSIDE CRITICAL RANGE CORRESPONDING TO BOX PLOT FROM PROCESS DATA — 425

END

FIG.4

**EP 4 752 580 A1**

## INTERNATIONAL SEARCH REPORT

| | International application No. |
|---|---|
| | **PCT/KR2024/012516** |

| A. | CLASSIFICATION OF SUBJECT MATTER |
|---|---|
| | **G01R 31/396**(2019.01)i; **G01R 31/367**(2019.01)i; **G01R 31/385**(2019.01)i; **G01R 19/165**(2006.01)i |

According to International Patent Classification (IPC) or to both national classification and IPC

| B. | FIELDS SEARCHED |
|---|---|

Minimum documentation searched (classification system followed by classification symbols)

G01R 31/396(2019.01); G01R 19/00(2006.01); G01R 31/36(2006.01); G01R 31/367(2019.01); G01R 31/385(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 공정(process), 데이터(data), 기준(reference), 프로파일(profile), 박스 플롯(box plot)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2022-0102472 A (LG ENERGY SOLUTION, LTD.) 20 July 2022 (2022-07-20) See paragraphs [0038]-[0079] and figures 1-4. | 1-4,6,8-11,13 |
| A | | 5,7,12,14 |
| Y | KR 10-2022-0114362 A (LG ENERGY SOLUTION, LTD.) 17 August 2022 (2022-08-17) See claim 1. | 1-4,6,8-11,13 |
| A | KR 10-2016-0046547 A (LG CHEM, LTD.) 29 April 2016 (2016-04-29) See paragraphs [0098]-[0136] and figures 1-2. | 1-14 |
| A | KR 10-2015-0033267 A (LG CHEM, LTD.) 01 April 2015 (2015-04-01) See paragraphs [0050]-[0057] and figure 1. | 1-14 |
| A | KR 10-2023-0010545 A (LG ENERGY SOLUTION, LTD.) 19 January 2023 (2023-01-19) See paragraphs [0034]-[0053] and figure 1. | 1-14 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **21 November 2024** | **21 November 2024** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/012516**

| Patent document cited in search report | | | Publication date (day/month/year) | Patent family member(s) | | | Publication date (day/month/year) |
|---|---|---|---|---|---|---|---|
| KR | 10-2022-0102472 | A | 20 July 2022 | CN | 115956207 | A | 11 April 2023 |
| | | | | EP | 4198536 | A1 | 21 June 2023 |
| | | | | JP | 2023-528058 | A | 03 July 2023 |
| | | | | JP | 7546700 | B2 | 06 September 2024 |
| | | | | US | 2023-0213589 | A1 | 06 July 2023 |
| | | | | WO | 2022-154545 | A1 | 21 July 2022 |
| KR | 10-2022-0114362 | A | 17 August 2022 | | None | | |
| KR | 10-2016-0046547 | A | 29 April 2016 | KR | 10-1711258 | B1 | 28 February 2017 |
| KR | 10-2015-0033267 | A | 01 April 2015 | KR | 10-1650041 | B1 | 22 August 2016 |
| KR | 10-2023-0010545 | A | 19 January 2023 | CN | 116324449 | A | 23 June 2023 |
| | | | | EP | 4206713 | A1 | 05 July 2023 |
| | | | | JP | 2023-538347 | A | 07 September 2023 |
| | | | | JP | 2024-137945 | A | 07 October 2024 |
| | | | | JP | 7498358 | B2 | 11 June 2024 |
| | | | | US | 2023-0366935 | A1 | 16 November 2023 |
| | | | | WO | 2023-287180 | A1 | 19 January 2023 |

Form PCT/ISA/210 (patent family annex) (July 2022)

**EP 4 752 580 A1**

## REFERENCES CITED IN THE DESCRIPTION

### Patent documents cited in the description

- KR 1020230117958